# DEMANDE DE BREVET EUROPEEN

(11) **EP 0 576 318 A1**
(43) Date de publication de la demande: **29.12.1993**
(21) Numéro de dépôt: 93401472.1
(22) Date de dépôt: 09.06.1993
(51) Int. Cl.: H04Q 1/14, H02B 1/20

(54) **Répartiteur matriciel, carte de circuit imprimé et procédé de gestion de répartiteur**

(30) Priorité: 18.06.1992 FR 9207444
(71) Demandeur: INGENIERIE BOGA, F-76400 Fécamp (FR)
(72) Inventeur: Lacombe, Jean-Jacques, F-76400 Fecamp (FR)
(74) Mandataire: Arnaud, Jean Pierre Alfred

(57) **Abrégé**

L'invention concerne un répartiteur matriciel.

Elle se rapporte à un répartiteur qui comprend un support (10) de circuit imprimé double face, ayant, dans un premier plan et dans un second plan, des emplacements de connexion disposés suivant des lignes et des colonnes (42, 44). Les éléments de raccordement sont des éléments interrupteurs ayant deux contacts reliés l'un à un emplacement d'une ligne et l'autre à un emplacement d'une colonne de la matrice. Des fiches de coupure séparent les contacts. Une connexion est donc établie par enlèvement d'une fiche de coupure.

Application aux répartiteurs téléphoniques.

## Description

La présente invention concerne un répartiteur matriciel, destiné à assurer la connexion sélective entre une ligne d'un premier ensemble de lignes de communication, par exemple un câble relié à un autocommutateur, et une ligne d'un second ensemble de lignes de communication, par exemple de lignes d'abonnés. Elle concerne aussi une carte de circuit imprimé destinée à un tel répartiteur matriciel, et un procédé de gestion d'un tel répartiteur matriciel.

Les répartiteurs téléphoniques sont des organes comprenant un premier ensemble d'emplacements de connexion et un second ensemble d'emplacements de connexion. Le premier ensemble est raccordé par exemple à des câbles relié à un autocommutateur et on l'appelle souvent "tête de câble". Le second ensemble d'emplacements de connexion est par exemple raccordé à des lignes d'abonnés, et on l'appelle souvent "réglette". Le raccordement d'un abonné comprend l'établissement d'une liaison entre une paires d'emplacements de connexion du premier ensemble et une paire d'emplacements de connexion du second ensemble ; cette liaison est habituellement réalisée par une "jarretière", c'est-à-dire une paire de fils de connexion. La pose des jarretières et, plus rarement, leur enlèvement ou leur modification, constituent l'essentiel du travail de gestion des répartiteurs téléphoniques, et ces opérations doivent être réalisés par du personnel expérimenté.

On a donc cherché à réduire ce travail de gestion. A cet effet, le brevet des Etats-Unis d'Amérique n° 3 796 848 concerne un élément de répartiteur ayant des broches de connexion. Cet élément de répartiteur comporte un support qui est une carte de circuit imprimé double face. Des lignes, pouvant former des lignes ou des colonnes d'une matrice, traversent la carte pour passer de l'autre côté puis revenir à un bord opposé sur la face opposée, et traversent à nouveau la carte pour revenir à des bornes.

On a aussi envisagé l'utilisation de robots de câblage. Etant donné les difficultés présentées par la réalisation des connexions par des robots, on a cherché à simplifier les opérations de connexion et de déconnexion, et on a étudié à cet effet l'utilisation de répartiteurs matriciels.

On connaît ainsi un répartiteur matriciel qui comporte, dans un premier plan, des lignes d'emplacements de connexion et, dans un second plan, des colonnes d'emplacements de connexion. Les lignes sont reliées à un premier ensemble de lignes de communication et les colonnes à un second ensemble de lignes de communication. Les emplacements de connexion des lignes et des colonnes, dans les deux plans, sont alignés en direction perpendiculaire à ces plans, et des trous sont formés aux positions d'alignement. Le raccordement entre une ligne et une colonne de la matrice, à un emplacement de connexion de chacun des plans, est assuré par introduction d'une broche conductrice. Une opération de raccordement d'abonné nécessite donc le prélèvement d'une broche conductrice, le positionnement précis de la broche en face d'un trou particulier, et l'introduction de la broche dans l'axe du trou. Le positionnement précis des broches nécessite donc soit l'utilisation d'appareils extrêmement élaborés de manutention- de ces broches, soit la réalisation d'un répartiteur matriciel ayant une très grande précision. Pour ces raisons, les répartiteurs matriciels actuellement proposés sont très onéreux.

L'invention concerne un répartiteur matriciel dont le coût est réduit, car il est réalisé à partir de composants existants de faible coût, et qui simplifie considérablement la gestion du répartiteur. En particulier, un raccordement, c'est-à-dire l'établissement d'une liaison entre une ligne d'un premier ensemble et une ligne d'un second ensemble, ne nécessite que l'extraction d'un organe de coupure.

Plus précisément, l'invention concerne un répartiteur matriciel, destiné à assurer la connexion sélective entre une ligne d'un premier ensemble de lignes de communication et une ligne d'un second ensemble de lignes de communication ; le répartiteurs comprend un support ayant, dans un premier plan, des emplacements de connexion connectés les uns aux autres suivant les lignes d'une matrice, et, dans un second plan, des emplacements de connexion connectés les uns aux autres suivant les colonnes de la matrice, et des éléments de raccordement qui sont raccordés chacun à un emplacement de connexion d'une ligne de la matrice et à un emplacement de connexion d'une colonne de la matrice. Selon l'invention, le support est une carte de circuit imprimé de type double face, le premier plan étant constitué par une face du circuit et le second plan par l'autre face, et les éléments de raccordement sont des éléments interrupteurs qui comportent deux contacts dont l'un est connecté à un emplacement de connexion d'une ligne de la matrice et l'autre est connecté à un emplacement de connexion d'une colonne de la matrice, et un élément de commande de l'élément interrupteur.

Dans un mode de réalisation très avantageux, les contacts d'un élément interrupteur sont des contacts rappelés élastiquement l'un vers l'autre, et l'élément de commande est un organe de coupure destiné à maintenir les contacts à distance l'un de l'autre et qui est retiré, de préférence, par déplacement en direction perpendiculaire aux plans du circuit imprimé.

Dans les applications téléphoniques, il est très avantageux que la matrice soit de type double, et que les éléments interrupteurs soient de type bipolaire, si bien que le raccordement sélectif est réalisé simultanément pour une paire de lignes.

Dans un mode de réalisation avantageux en pratique, les éléments interrupteurs bipolaires sont regroupés en modules disposés suivant les lignes ou suivant les colonnes de la matrice.

De préférence, la carte de circuit imprimé porte, près d'un bord au moins, un connecteur permettant la connexion de l'un des ensembles de lignes de communication ou d'une partie de l'un des ensembles de lignes de communication. Lorsque le répartiteur doit pouvoir être agrandi, il est avantageux que la carte de circuit imprimé porte, près d'un bord au moins, un connecteur permettant la connexion à un connecteur d'un autre répartiteur matriciel. Dans un mode de réalisation, chaque connecteur de la carte de circuit imprimé peut être utilisé indifféremment pour la connexion d'un ensemble de lignes ou d'un autre répartiteur matriciel.

Dans un mode de réalisation très avantageux, tous les éléments de commande des éléments interrupteurs sont visibles sur une même face du répartiteur matriciel.

Il est avantageux que le répartiteur comporte en outre un organe de repérage des lignes et des colonnes de la matrice permettant la localisation des éléments de commande. Dans un mode de réalisation, l'organe de repérage comprend des indications disposées sur les éléments de commande eux-mêmes. Dans un autre mode de réalisation, l'organe de repérage comprend des indications disposées autour de la matrice.

L'invention concerne aussi une carte de circuit imprimé de type double face, de forme rectangulaire ou carrée, destinée à un répartiteur matriciel tel que défini dans les précédents paragraphes.

L'invention concerne enfin un procédé de gestion d'un répartiteur matriciel dont les lignes d'emplacements de connexion de la matrice sont connectées à un premier ensemble de lignes de communication et les colonnes d'emplacements de connexion de la matrice sont connectées à un second ensemble de lignes de communication, un emplacement de ligne de la matrice et un emplacement de colonne de la matrice étant raccordés par des contacts rappelés l'un vers l'autre et séparés par un organe de coupure ; selon l'invention, l'exécution du raccordement d'une ligne de communication du premier ensemble à une ligne de communication du second ensemble comprend l'enlèvement d'un organe de coupure. De préférence, la suppression d'un raccordement entre une ligne de communication du premier ensemble et une ligne de communication du second ensemble comprend l'introduction d'un organe de coupure entre les contacts.

D'autres caractéristiques et avantages de l'invention seront mieux compris à la lecture de la description qui va suivre d'exemples de réalisation, faite en référence aux dessins annexés sur lesquels :
la figure 1 est une vue en plan d'une face d'une carte de circuit imprimé d'un répartiteur matriciel selon l'invention ;
la figure 2 est une vue en plan de l'autre face de la carte de circuit de la figure 1 ;
la figure 3 est une vue en perspective d'un module d'éléments interrupteurs, disponible dans le commerce et qui peut être monté sur la carte des figures 1 et 2 ;
la figure 4 est un organe de coupure utilisé pour la formation d'un raccordement dans un module représenté sur la figure 3 ; et
la figure 5 est une vue en plan d'un répartiteur matriciel selon l'invention, réalisé à partir des éléments représentés sur les figures 1 à 4.

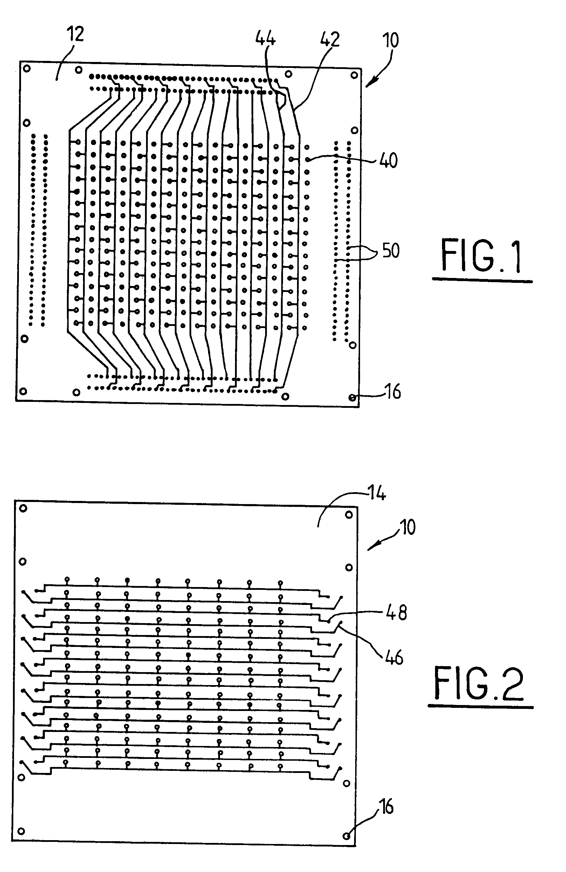

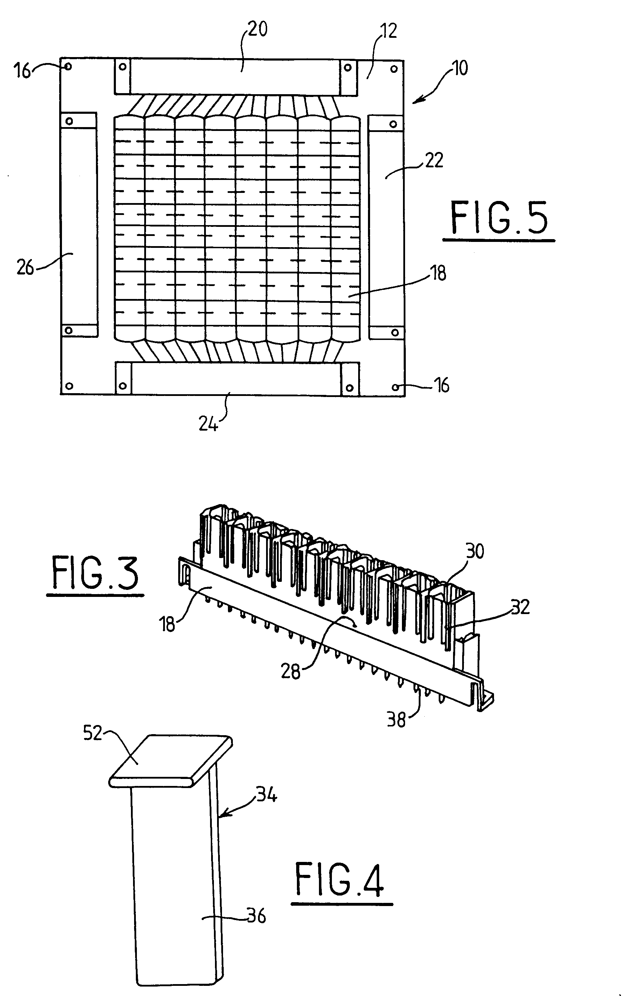

Le répartiteur matriciel selon l'invention est réalisé à partir d'une carte de circuit imprimé, désignée par la référence 10 sur les figures 1 et 2, de type double face, et de modules d'éléments interrupteurs, tels que représentés sur la figure 3 et appelés "amorces à coupure" dans le commerce, leur fiche de coupure étant représentée sur la figure 4. Un répartiteur matriciel selon l'invention ne comporte que des connecteurs, en plus de ces éléments.

Plus précisément, la figure 5 représente la disposition générale d'un répartiteur matriciel selon l'invention. La carte de circuit imprimé 10 a une face "supérieure" 12 (ainsi appelée parce qu'elle porte les modules d'éléments de raccordement) qui est représentée sur la figure 1, et une face "inférieure" 14 qui est représentée sur la figure 2, et des trous 16 placés à ses coins permettent sa fixation sur un support quelconque. La face supérieure porte huit modules 18 d'éléments de raccordement, et quatre connecteurs 20, 22, 24, 26 placés sur les quatre bords de la carte.

Les modules 18 d'éléments interrupteurs, utilisés dans le mode de réalisation considéré, sont des modules connus sous le nom de "modules de raccordement avec coupure" disponibles par exemple sous la référence SJS C2 de la Société Pouyet. Les modules représentés comportent un corps 28 de matière plastique moulée qui délimite une série de logements 30. Sur la figure 3, le corps 28 comporte dix logements. Cependant, sur la figure 5, les modules utilisés ne comportent que huit logements. Chaque logement a quatre fentes 32 destinées au passage d'un fil et munies, à l'intérieur, d'un contact auto-dénudant. Ces contacts comportent une partie élastique qui est normalement en appui contre une partie élastique correspondante du contact auto-dénudant placé en face dans le même logement. Cependant, des fiches de coupure 34, introduites dans les logements 30, séparent, par leur corps isolant 36, les contacts des deux paires. Ces contacts sont en outre reliés chacun à une broche 38 dépassant sous le corps 28. Celui-ci comporte ainsi quatre broches 38 par logement 30.

Dans le répartiteur matriciel de ce mode de réalisation de l'invention, une caractéristique importante est la présence des contacts élastiques qui viennent en appui l'un contre l'autre et sont maintenus à distance par la fiche de coupure 34. La présence des contacts auto-dénudants, qui ne sont pas nécessaires à l'invention, permet cependant d'une variante de réalisation de l'invention, décrite dans la suite. Une caractéristique pratique importante de l'invention est que les modules 18 sont des composants très courants, fabriqués en grande série et disponibles à un coût relativement faible.

La figure 5 indique la présence de huit modules parallèles, ayant chacun huit logements, c'est-à-dire que chaque module a trente-deux broches 38. La fixation des broches 38 à la carte 10 de circuit imprimé nécessite donc la présence de deux cent cinquante six trous de connexion dans la carte 10. Ces trous sont représentés sur la figure 1. Au contraire, la figure 2 ne représente que ceux qui sont connectés aux trajets conducteurs de cette face. Sur la figure 1, on note qu'une colonne sur deux de trous est connectée à deux lignes ou trajets de connexion 42, 44, formés sur la face supérieure de circuit imprimé. Les trous des lignes qui ne sont pas connectées sur la figure 1 sont connectés par d'autres lignes ou trajets de connexion 46, 48 représentés sur la figure 2. On peut considérer que les lignes de connexion 42, 44 de la figure 1 constituent les colonnes d'une matrice et les lignes 46, 48 représentées sur la figure 2 représentent les lignes de cette matrice. On note aussi sur la figure 1 que, dans les séries de trous reliées aux lignes 42, 44, un trou sur deux est relié à la ligne 42 et les autres trous à la ligne 44. Les contacts élastiques des modules 18 permettent la liaison d'une des lignes 42, 44, correspondant à une colonne de la matrice, et d'une des lignes 46, 48, correspondant à une ligne de la matrice.

La disposition en lignes et colonnes d'un répartiteur matriciel est déjà connue. La caractéristique importante selon l'invention est cependant le fait que les connexions entre lignes et colonnes de la matrice est réalisée par des modules dont les contacts sont normalement rappelés en position de fermeture et qui sont écartés uniquement par la présence des fiches de coupure 34.

Normalement, lorsque le répartiteur matriciel est livré à un client, tous les logements 30 de tous les modules contiennent une fiche de coupure 34, c'est-à-dire qu'il n'existe aucune connexion entre les lignes et les colonnes. Les connexions entre lignes et colonnes ne sont réalisées, aux endroits spécifiés, que par enlèvement des fiches de coupure 34 concernées.

On note, sur la figure 5, que les lignes 42, 44 de connexion qui sont formées sur la face supérieure rejoignent, à deux bords de la carte, les connecteurs 20, 24. L'un des connecteurs est destiné à coopérer avec un connecteur complémentaire qui est raccordé par exemple à un câble provenant d'un autocommutateur, c'est-à-dire à un premier ensemble de lignes de communication. L'autre connecteur 24 permet la connexion à d'autres cartes analogues de répartiteur, comme indiqué dans la suite.

Les connecteurs 22 et 26 placés aux deux autres bords de la carte 10 sont reliés aux lignes de connexion 46, 48. Le connecteur 22 est par exemple destiné à coopérer avec un connecteur complémentaire qui est relié à un second ensemble de lignes de connexion, par exemple des lignes d'abonnés. Le connecteur 26 peut être utilisé pour la connexion d'un autre répartiteur matriciel le cas échéant. Les connecteurs 20 à 26 sont de type bien connu, ayant des broches dépassant à la face inférieure et qui pénètrent dans les séries de trous telles que 50 indiquées sur la figure 1. Toutes les broches sont soudées à la face inférieure de la carte de circuit imprimé. De préférence, tous les connecteurs sont du même type.

On a indiqué la présence des connecteurs 24, 26. Ceux-ci sont avantageux parce qu'ils permettent la disposition de plusieurs cartes raccordées les unes aux autres, dans deux directions perpendiculaires. De cette manière, la capacité du répartiteur matriciel peut être augmentée à volonté.

On note sur la figure 1 que tous les modules se trouvent dans un même plan. Lorsque les fiches de coupure 34 sont placées dans leur logement, leurs extrémités plates 52 se trouvent toutes dans un plan. Comme indiqué précédemment, l'établissement d'un raccordement comprend la simple opération d'arrachement d'une fiche de coupure 34. L'établissement d'un tel raccordement est donc facilité par la présence d'organes ou d'éléments de repérage, c'est-à-dire d'indications permettant la détermination sans équivoque de l'emplacement de la fiche de coupure qui doit être retirée. Ce repérage peut être réalisé par disposition d'échelles sur les côtés, indiquant les coordonnées telles que X, Y de la matrice, par exemple sur les connecteurs ou sur un capot qui les recouvre. Il peut aussi être obtenu par une indication portée par chaque fiche de coupure elle-même, par exemple par disposition de signes convenables sur la tête 52 de la fiche de coupure 34.

L'établissement d'un raccordement peut aussi être réalisé par un robot. Dans ce cas, il suffit que le robot comporte un doigt qui écarte simplement la fiche de coupure qui peut ensuite tomber sous son propre poids, par exemple lorsque le répartiteur matriciel est incliné.

On a décrit un répartiteur matriciel comprenant des modules raccordés suivant une matrice de lignes de connexion, et dans lequel les extrémités des lignes ou trajets de connexion rejoignent des connecteurs. Cependant, un répartiteur matriciel plus simple peut être réalisé. Certains connecteurs au moins sont supprimés, et la carte de circuit imprimé 10 peut donc avoir une dimension réduite. Dans ce cas, les lignes de connexion 42, 44 s'arrêtent à la hauteur des derniers trous des colonnes de trous. De même, les lignes ou trajets de connexion s'arrêtent à la hauteur des derniers trous des lignes. Les connexions des lignes du premier ensemble, par exemple de lignes d'abonnés, s'effectuent simplement à l'aide des contacts auto-dénudants placés dans les fentes 32 d'un module d'extrémité. Les connexions à l'autre ensemble de lignes de communication, par exemple des têtes de câbles, s'effectuent aux contacts auto-dénudants analogues d'extrémité de tous les modules 18. Par exemple, sur la figure 5, les lignes d'un premier ensemble de connexion sont raccordées aux contacts auto-dénudants des parties supérieures de tous les modules. L'autre ensemble de lignes de connexion est connecté aux contacts auto-dénudants du module de droite. Bien entendu, un ensemble de lignes de connexion est connecté aux parties droite ou gauche des logements 30 alors que l'autre ensemble de lignes de connexion est connecté aux parties gauche ou droite respectivement des logements 30.

Ce dernier mode de réalisation de répartiteur matriciel est particulièrement peu onéreux et occupe un volume très réduit.

On a décrit un mode de réalisation de répartiteur matriciel particulièrement avantageux, car il utilise des composants bien connus dans la technique et de faible coût dû à leur fabrication en grande série. Cependant, on peut utiliser des éléments interrupteurs d'autres types. Dans le mode de réalisation décrit, il est très avantageux d'utiliser un simple arrachement d'une fiche de coupure, car l'extraction d'un organe est toujours beaucoup plus facile à réaliser que l'introduction d'un organe puisque celle-ci nécessite un positionnement précis. En outre, une caractéristique avantageuse de ce mode de réalisation est que les organes qui sont manipulés sont des organes isolants, qui sont légers et qui ne peuvent pas créer de court-circuit en cas de chute.

Ainsi, la gestion d'un répartiteur matriciel selon l'invention est extrêmement simplifiée, car l'exécution d'un raccordement entre une ligne de communication du premier ensemble et une ligne de communication du second ensemble comprend simplement l'enlèvement d'un organe de coupure. Il faut se rappeler que c'est cette opération de raccordement qui est la plus fréquente. Une opération de déconnexion, par exemple d'une ligne d'abonnés, s'effectue simplement par introduction de la fiche de coupure dans le logement correspondant du répartiteur. La localisation de ce logement est facile puisque le nombre de fiches de coupure retirées est relativement réduit. Dans l'exemple de la figure 5, lorsque huit lignes d'abonnés ont été connectées à huit lignes de têtes de câbles, seules huit fiches de coupure ont été retirées sur les soixante-quatre présentes. En outre, les fiches de coupure adjacentes dans les directions des lignes et des colonnes sont obligatoirement présentes. Il est donc très facile de repérer les emplacements dont la fiche de coupure a été retirée et de remettre une telle fiche pour assurer la déconnexion.

Ainsi, l'invention concerne un répartiteur téléphonique matriciel de réalisation très simple, de coût réduit et dont la gestion est extrêmement simplifiée et peut être réalisée par du personnel très peu expérimenté.

## Revendications

1. Répartiteur matriciel, destiné à assurer la connexion sélective entre une ligne d'un premier ensemble de lignes de communication et une ligne d'un second ensemble de lignes de communication, du type qui comprend
- un support (10) ayant, dans un premier plan, des emplacements de connexion connectés les uns aux autres suivant les lignes (46, 48) d'une matrice, et, dans un second plan, des emplacements de connexion connectés les uns aux autres suivant les colonnes (42, 44) de la matrice, et
- des éléments de raccordement qui sont raccordés chacun à un emplacement de connexion d'une ligne de la matrice et à un emplacement de connexion d'une colonne de la matrice,
caractérisé en ce que
- le support est une carte (10) de circuit imprimé double face, le premier plan étant constitué par une face du circuit et le second plan par l'autre face, et
- les éléments de raccordement sont des éléments interrupteurs comprenant deux contacts dont l'un est connecté à un emplacement de connexion d'une ligne de la matrice et l'autre est connecté à un emplacement de connexion d'une colonne de la matrice, et un élément de commande (34) de l'élément interrupteur.

2. Répartiteur selon la revendication 1, caractérisé en ce que les contacts d'un élément interrupteur sont des contacts rappelés élastiquement l'un vers l'autre, et l'élément de commande est un organe de coupure (34) destiné à maintenir les contacts à distance l'un de l'autre.

3. Répartiteur selon l'une des revendications 1 et 2, caractérisé en ce que la matrice est de type double, et les éléments interrupteurs sont de type bipolaire, si bien que la connexion sélective est réalisée simultanément pour une paire de lignes (42, 44 ; 46, 48).

4. Répartiteur selon l'une quelconque des revendications précédentes, caractérisé en ce que les éléments interrupteurs bipolaires sont regroupés en modules (18) disposés suivant les lignes ou les colonnes de la matrice.

5. Répartiteur selon l'une quelconque des revendications précédentes, caractérisé en ce que la carte (10) de circuit imprimé porte, près d'un bord au moins, un connecteur (20, 22, 24, 26) permettant la connexion de l'un des ensembles de lignes de communication ou d'une partie de l'un des ensembles de lignes de communication.

6. Répartiteur selon la revendication 5, caractérisé en ce que les connecteurs (20, 22, 24, 26) de la carte de circuit imprimé peuvent être utilisés indifféremment pour la connexion d'un ensemble de lignes ou d'un autre répartiteur matriciel.

7. Répartiteur selon l'une quelconque des revendications précédentes, caractérisé en ce qu'il comporte en outre un organe (52) de repérage des lignes et des colonnes de la matrice permettant la localisation des éléments de commande.

8. Carte (10) de circuit imprimé de type double face, de forme rectangulaire ou carrée, destinée à un répartiteur matriciel selon l'une quelconque des revendications précédentes.

9. Procédé de gestion d'un répartiteur matriciel dont les lignes (46, 48) d'emplacements de connexion de la matrice sont connectées à un premier ensemble de lignes de communication et les colonnes (42, 44) d'emplacements de connexion de la matrice sont connectées à un second ensemble de lignes de communication, un emplacement de ligne de la matrice et un emplacement de colonne de la matrice étant raccordés par des contacts rappelés l'un vers l'autre et séparés par un organe de coupure (34), caractérisé en ce qu'il comprend l'exécution du raccordement d'une ligne de communication du premier ensemble à une ligne de communication du second ensemble par enlèvement de l'organe de coupure (34).

10. Procédé selon la revendication 9, caractérisé en ce qu'il comprend la suppression d'un raccordement entre une ligne de communication du premier ensemble et une ligne de communication du second ensemble par introduction d'un organe de coupure (34) entre les contacts.
